# EUROPÄISCHE PATENTANMELDUNG

(11) **EP 4 741 844 A2**
(43) Veröffentlichungstag der Anmeldung: **13.05.2026**
(21) Anmeldenummer: 26169511.8
(22) Anmeldetag: 18.12.2023
(51) Int. Cl.: G01R 31/14

(54) **SYSTEM UND VERFAHREN SOWIE HOCHSPANNUNGSPRÜFSIGNALVORRICHTUNG FÜR EINE MULTIFUNKTIONALE PRÜFUNG EINER HOCHSPANNUNGSEINRICHTUNG**

(30) Priorität: 21.12.2022 AT 509842022
(62) Teilanmeldung aus: 23834041.8
(71) Anmelder: Omicron electronics GmbH, 6833 Klaus (AT)
(72) Erfinder: RÄDLER, Michael, 6832 Röthis (AT); KAUFMANN, Reinhard, 6721 Thüringerberg (AT)
(74) Vertreter: Kraus & Lederer PartGmbB

(57) **Zusammenfassung**

Ein Prüfsystem (10) für eine multifunktionale Prüfung einer Hochspannungseinrichtung (30) umfasst eine Hochspannungsprüfsignalvorrichtung (200), eine Messeinrichtung (160) und eine Steuerungseinrichtung (180). Die Hochspannungsprüfsignalvorrichtung (200) kann gesteuert durch die Steuerungseinrichtung (180) in einem Verlustfaktor-Modus für eine Verlustfaktorprüfung der Hochspannungseinrichtung und in einem Isolationswiderstand-Modus für eine Isolationswiderstandsprüfung der Hochspannungseinrichtung betrieben werden, so dass mit ein und demselben Prüfsystem beide Prüfungen durchgeführt werden können.

## Beschreibung

### GEBIET DER ERFINDUNG

Die Erfindung liegt auf dem Gebiet der Hochspannungsmesstechnik und betrifft insbesondere ein Prüfsystem für eine multifunktionale Prüfung einer Hochspannungseinrichtung, eine Hochspannungsprüfsignalvorrichtung dafür sowie ein Verfahren dafür.

### HINTERGRUND

In elektrischen Energieversorgungsnetzen werden üblicherweise Hochspannungseinrichtungen wie Leistungstransformatoren oder Schaltanlagen - insbesondere gasisolierte Schaltanlagen - zum Wandeln und Verteilen von elektrischer Energie eingesetzt. Auch werden hierbei gewöhnlich weitere Hochspannungseinrichtungen wie Hochspannungswandler oder Hochstromwandler - etwa zum Messen von in einem Stromnetz auftretenden Spannungen und Strömen -, Leistungsschalter und Leistungsgeneratoren eingesetzt. Auch im industriellen Umfeld finden solche Hochspannungseinrichtungen oder andere Hochspannungseinrichtungen wie elektrische (Leistungs-) Motoren Anwendung. Unter "Hochspannung" werden dabei im Rahmen der vorliegenden Erfindung Spannungen in der Größenordnung von mindestens 1kV verstanden, so dass unter "Hochspannungseinrichtung" eine mit einer derartig hohen Spannung betriebene Einrichtung verstanden wird.

Zur Inbetriebnahme oder zur Wartung von Anlagen mit solchen Hochspannungseinrichtungen kann es erforderlich sein, deren Funktionen und Eigenschaften zu überprüfen. Hierbei kann beispielsweise ein Isolationsmaterial von einer Hochspannungseinrichtung - wie einem Hochspannungs-Stromwandler, einem Hochspannungs-Spannungswandler oder einem Leistungsschalter - etwa mittels einer Messung des Gleichspannungswiderstands überprüft werden. Auch kann hierbei ein Verlustfaktor von einer Hochspannungseinrichtung - wie einem Leistungstransformator oder einer rotierenden Maschine, z.B. einem Generator oder einem Elektromotor - gemessen werden, was auch Informationen über die Qualität von vorhandenen Isoliermaterialien oder Isolierflüssigkeiten liefern kann. Auch kann eine Teilentladungsmessung durchgeführt werden. Derartige Messungen sind besonders relevant, da Isoliermaterialien - wie etwa das Öl eines Transformators - einer Alterung unterliegen können und folglich eine regelmäßige Überprüfung zur Sicherstellung der Betriebssicherheit der Hochspannungseinrichtung notwendig sein kann.

Derartige Messungen werden häufig im Feldeinsatz - also beispielsweise im Außenbereich oder in einer industriellen Umgebung - durchgeführt. Dabei sollen die verwendeten Gerätschaften besonders für den Feldeinsatz ein geringes Gewicht haben und für den Transport zum jeweiligen Einsatzort robust sein.

Die US 2017 / 016 949 A1, die WO 2021 / 140 211 A1, die WO 2021 / 228 841 A1 und die JP S62 55571 A offenbaren jeweils Prüfsysteme für multifunktionale Prüfungen von Hochspannungseinrichtungen mit Primär- und Sekundärseite, welche eine Hochspannungssignalquelle und eine Messeinrichtung aufweisen. Dabei kann sowohl eine Verlustfaktorprüfung als auch eine Isolationswiderstandsprüfung durch Umschalten zwischen entsprechenden Betriebsmodi durchgeführt werden.

### ZUSAMMENFASSUNG DER ERFINDUNG

Es besteht daher ein Bedarf, das Prüfen von Funktionen und Eigenschaften von Hochspannungseinrichtungen zu verbessern und dabei insbesondere eine Handhabung eines Prüfsystems und einer Hochspannungsprüfsignalvorrichtung dafür zu vereinfachen, deren Transport zu erleichtern und ein Verfahren dafür effizienter und/oder sicherer zu machen.

Diese Aufgabe wird erfindungsgemäß durch ein Prüfsystem mit den Merkmalen des Anspruchs 1 und ein Prüfverfahren mit den Merkmalen des Anspruchs 8 gelöst. Die abhängigen Ansprüche definieren bevorzugte und/oder vorteilhafte Ausführungsformen der Erfindung.

Die vorliegende Erfindung ermöglicht, in lediglich einem Prüfsystem sowohl eine Verlustfaktorprüfung bzw. Tan/Delta-Prüfung als auch eine Isolationswiderstandsprüfung als Hochspannungsmessungen zu kombinieren, so dass beide Prüfungen ohne Umverkabelungen durchgeführt werden können.

Ein erster Aspekt der Erfindung betrifft insbesondere ein Prüfsystem für eine multifunktionale Prüfung einer Hochspannungseinrichtung. Eine solche zu prüfende Hochspannungseinrichtung weist eine Primärseite mit einem oder mehreren Primäranschlüssen und eine davon elektrisch isolierte Sekundärseite mit einem oder mehreren Sekundäranschlüssen auf. Das Prüfsystem weist eine Hochspannungsprüfsignalvorrichtung, eine Messeinrichtung und eine Steuerungseinrichtung auf.

Die Hochspannungsprüfsignalvorrichtung weist eine hochspannungsfähige Signalquelle auf, die eingerichtet ist, eine Wechselspannung sowie eine Gleichspannung mit einem entsprechend hohen Spannungswert zu erzeugen. Unter "Hochspannung" werden dabei im Rahmen der vorliegenden Erfindung Spannungen in der Größenordnung von mindestens 1kV verstanden. Zudem weist die Hochspannungsprüfsignalvorrichtung mindestens einen Hochspannungsanschluss zum Anschließen der Hochspannungseinrichtung sowie eine Stromsensoreinrichtung zum Erfassen eines über den mindestens einen Hochspannungsanschluss fließenden elektrischen Stroms und eine Hochspannungssensoreinrichtung zum Erfassen einer an dem Hochspannungsanschluss anliegenden elektrische Spannung auf.

Dabei ist die Hochspannungsprüfsignalvorrichtung mindestens in einem Verlustfaktor-Modus für eine Verlustfaktorprüfung der Hochspannungseinrichtung und in einem Isolationswiderstand-Modus für eine Isolationswiderstandsprüfung der Hochspannungseinrichtung betreibbar. Im Verlustfaktor-Modus legt die Hochspannungsprüfsignalvorrichtung die Wechselspannung an den mindestens einen Hochspannungsanschluss an, während im Isolationswiderstand-Modus die Hochspannungsprüfsignalvorrichtung die Gleichspannung an den mindestens einen Hochspannungsanschluss anlegt. Die Steuerungseinrichtung ist eingerichtet, für die Verlustfaktorprüfung die Hochspannungsprüfsignalvorrichtung im Verlustfaktor-Modus zu betreiben und mittels der Messeinrichtung anhand des von der Stromsensoreinrichtung erfassten Stroms einen Verlustfaktor der zu prüfenden Hochspannungseinrichtung zu bestimmen. Außerdem ist die Steuerungseinrichtung eingerichtet, für die Isolationswiderstandsprüfung die Hochspannungsprüfsignalvorrichtung im Isolationswiderstand-Modus zu betreiben und mittels der Messeinrichtung anhand des von der Stromsensoreinrichtung erfassten Stroms und anhand der von der Hochspannungssensoreinrichtung erfassten Spannung einen Gleichspannungs-Isolationswiderstand der zu prüfenden Hochspannungseinrichtung zu bestimmen.

Die Hochspannungsprüfsignalvorrichtung weist einen Messanschluss und eine weitere Spannungssensoreinrichtung, die eingerichtet ist, eine an dem Messanschluss anliegende elektrische Spannung zu erfassen, auf,
wobei die Hochspannungsprüfsignalvorrichtung in einem Übersetzungsverhältnis-Modus für eine Übersetzungsverhältnisprüfung der Hochspannungseinrichtung betreibbar ist, für welche die Primärseite der Hochspannungseinrichtung an den Hochspannungsanschluss und die Sekundärseite der Hochspannungseinrichtung an den Messanschluss anzuschließen ist,
wobei die Hochspannungsprüfsignalvorrichtung eingerichtet ist, in dem Übersetzungsverhältnis-Modus die Wechselspannung mittels der hochspannungsfähigen Signalquelle zu erzeugen und an den Hochspannungsanschluss anzulegen, und
wobei die Steuerungseinrichtung eingerichtet ist, für die Übersetzungsverhältnisprüfung die Hochspannungsprüfsignalvorrichtung in dem Übersetzungsverhältnis-Modus zu betreiben und mittels der Messeinrichtung anhand der von der Hochspannungssensoreinrichtung erfassten Spannung und anhand der von der weiteren Spannungssensoreinrichtung erfassten Spannung, welche infolge der an die Primärseite der Hochspannungseinrichtung anliegenden Wechselspannung an der Sekundärseite der Hochspannungseinrichtung und damit an dem Messanschluss anliegt, ein Übersetzungsverhältnis der Hochspannungseinrichtung zu bestimmen.

Dabei ist die Hochspannungseinrichtung ein Spannungswandler,
wobei die Hochspannungsprüfsignalvorrichtung weiterhin in einem erweiterten Übersetzungsverhältnis-Modus betreibbar ist, und
wobei die Steuerungseinrichtung eingerichtet ist, für eine erweiterte Übersetzungsverhältnisprüfung die Hochspannungsprüfsignalvorrichtung in dem erweiterten Übersetzungsverhältnis-Modus zu betreiben, um die Hochspannungsprüfsignalvorrichtung zu veranlassen, eine Wechselspannung mittels der hochspannungsfähigen Signalquelle zu erzeugen, welche wenigstens zwei Frequenzanteile mit unterschiedlichen Effektivwerten aufweist, und mittels der Messeinrichtung anhand der von der Hochspannungssensoreinrichtung erfassten Spannung und anhand der von der weiteren Spannungssensoreinrichtung erfassten Spannung ein Kennfeld von Übersetzungsverhältnissen der Hochspannungseinrichtung in Abhängigkeit von den Frequenzanteilen und deren Effektivwerten zu bestimmen.

Mit Hilfe der Erfindung kann somit sowohl eine Verlustfaktorprüfung bzw. Tan/Delta-Prüfung als auch eine Isolationswiderstandprüfung in Form entsprechender Hochspannungsmessungen in ein und demselben Prüfsystem ohne Umverkabelung, d.h. mit den gleichen Anschlusskabeln und an den gleichen Anschlüssen, realisiert werden, was die Flexibilität des Prüfsystems entsprechend erhöht und den Verkabelungsaufwand für die Durchführung dieser verschiedenen Prüfungen bzw. Messungen reduziert. Die beiden Prüfungen können somit auch effizienter und/oder sicherer durchgeführt werden. Durch die Kombination beider Prüfungen in einem Prüfsystem ist zudem ein einfacherer Transport zu einem Feldeinsatz möglich.

Vorzugsweise ist das Prüfsystem dabei als tragbares Prüfsystem oder Prüfgerät ausgestaltet. Bei einer bevorzugten Ausführungsform der Erfindung umfasst das Prüfsystem ein portables Hauptgerät und ein damit elektrisch koppelbares portables Zusatzgerät, wobei das portable Hauptgerät die Messeinrichtung, die Steuerungseinrichtung und eine Leistungsverstärkereinrichtung aufweist, während das portable Zusatzgerät die Hochspannungsprüfsignalvorrichtung aufweist.

Im Sinne der Erfindung ist unter einer "Hochspannungseinrichtung" zumindest eine Einrichtung - etwa als Teil einer Hochspannungsanlage zur Energieversorgung oder als Teil einer elektrisch betriebenen Produktionsanlage - zu verstehen, welche mit einer hohen elektrischen Spannung oder einem hohen elektrischen Strom betrieben wird, eine(n) solchen steuert, wandelt oder misst oder aus einem sonstigen Grund einer hohen elektrischen Spannung ausgesetzt sein kann und dabei für einen sicheren Betrieb - etwa durch ausreichende elektrische Isolierung - eingerichtet sein soll. Wie oben erwähnt ist die Hochspannungseinrichtung ein Hochspannungs-Spannungsmesswandler (kurz Spannungswandler) .

Wie bereits erwähnt, ist im Sinne der Erfindung unter einer "hohen Spannung" oder einer "Hochspannung" eine elektrische Spannung in der Größenordnung von mindestens 1kV zu verstehen. Bei einer elektrischen Wechselspannung kann sich der Wert hierbei auf die Amplitude oder den Effektivwert der Wechselspannung beziehen, bei einer Gleichspannung auf den Gleichspannungsanteil und ansonsten auf die betragsmäßig größten Spitzenwerte oder Effektivwerte.

Eine Ausführungsform der Erfindung mit einer Gleichrichtereinrichtung, mittels der die Wechselspannung gleichgerichtet und als die Gleichspannung bereitgestellt wird, kann insbesondere den Vorteil haben, dass für beide Prüfungen die hochspannungsfähige Signalquelle einen Hochspannungstransformator zum Erzeugen von Hochspannungen sowohl für die Wechselspannung als auch für die Gleichspannung verwenden kann, wodurch sich insbesondere der Aufbau des Prüfsystems vereinfachen und/oder dessen Gewicht reduzieren lässt.

Ein dritter Aspekt der Erfindung betrifft ein Verfahren für eine multifunktionale Prüfung einer Hochspannungseinrichtung, wobei das Verfahren die folgenden von einem Prüfsystem automatisch durchgeführten Schritte umfasst:
- Erzeugen einer Wechselspannung durch das Prüfsystem und Anlegen der Wechselspannung an die Hochspannungseinrichtung,
- Erfassen eines elektrischen Wechselstroms, der in Folge der Wechselspannung über die Hochspannungseinrichtung fließt,
- Bestimmen eines Verlustfaktors anhand des erfassten Wechselstroms,
- Erzeugen einer Gleichspannung durch das Prüfsystem und Anlegen der Gleichspannung an die Hochspannungseinrichtung,
- Erfassen eines elektrischen Gleichstroms, der in Folge der Gleichspannung über die Hochspannungseinrichtung fließt, und
- Bestimmen eines Gleichspannungs-Isolationswiderstands der Hochspannungseinrichtung anhand des erfassten Gleichstroms und anhand der Gleichspannung.

Zur Durchführung des Verfahrens wird ein Prüfsystem gemäß einem der Ausführungsbeispiele der Erfindung verwendet werden.

Die bereits vorausgehend genannten möglichen Vorteile, Ausführungsformen, Weiterbildungen oder Varianten der jeweils vorhergehenden Aspekte der Erfindung gelten entsprechend auch für die erfindungsgemäße Hochspannungsprüfsignalvorrichtung und für das erfindungsgemäße Verfahren. Weitere Vorteile, Merkmale und Anwendungsmöglichkeiten ergeben sich aus der nachfolgenden detaillierten Beschreibung von Ausführungsbeispielen und/oder aus der Figur.

### KURZE BESCHREIBUNG DER FIGUREN

Die Erfindung wird nachfolgend unter Bezugnahme auf eine Figur sowie anhand vorteilhafter Ausführungsbeispiele näher erläutert.

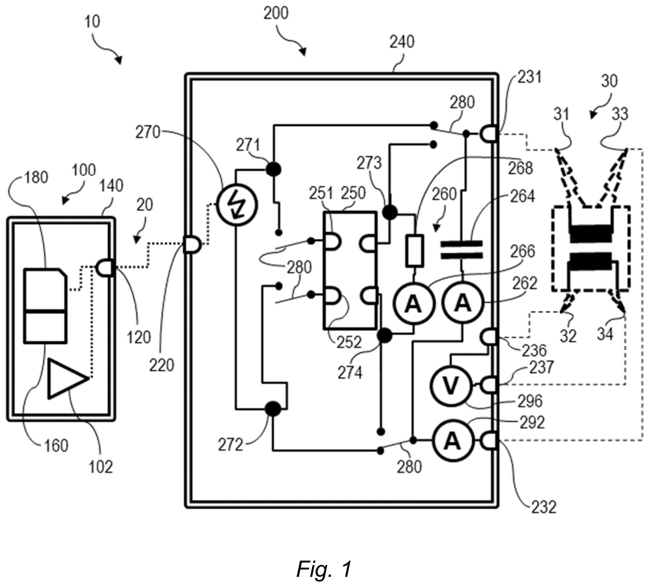

Dabei zeigt Fig. 1, teilweise schematisiert, ein Prüfsystem mit einer Hochspannungsprüfsignalvorrichtung nach einer Ausführungsform.

In Fig. 1 dargestellte Elemente und/oder Bauteile sind nicht notwendigerweise maßstabsgetreu dargestellt. Vielmehr sind dargestellte Elemente und/oder Bauteile derart wiedergegeben, dass ihre Funktion und/oder ihr Zweck dem Fachmann verständlich werden. Dabei können dargestellte Verbindungen und Kopplungen zwischen funktionellen Einheiten und Elementen auch als indirekte Verbindungen oder Kopplungen implementiert werden. Insbesondere können Datenverbindungen drahtgebunden oder drahtlos, also insbesondere als Funkverbindung, ausgebildet sein. Auch können bestimmte Verbindungen, etwa elektrische Verbindungen, etwa zur Energieversorgung, der Übersichtlichkeit halber nicht dargestellt sein.

### DETAILLIERTE BESCHREIBUNG VON AUSFÜHRUNGSBEISPIELEN

In Fig. 1 ist ein Prüfsystem 10 nach einer Ausführungsform der vorliegenden Erfindung für eine multifunktionale Prüfung einer Hochspannungseinrichtung dargestellt.

In Fig. 1 ist darüber hinaus auch die zu prüfende Hochspannungseinrichtung 30 dargestellt. Zum Prüfen wird die Hochspannungseinrichtung 30 - insbesondere über eine Verkabelung (dargestellt durch gestrichelte Linien) - mit dem Prüfsystem 10 verbunden. Die Hochspannungseinrichtung 30 weist eine Primärseite mit einem ersten Primäranschluss 31 und einem zweiten Primäranschluss 33 sowie eine davon elektrisch isolierte Sekundärseite mit einem ersten Sekundäranschluss 32 und einem zweiten Sekundäranschluss 34 auf. In alternativen Varianten weist die Hochspannungseinrichtung 30 nur einen Primäranschluss oder nur einen Sekundäranschluss oder auch zusätzliche Anschlüsse auf. Im Folgenden wird zunächst für einige Varianten eines Ausführungsbeispiels eine erweiterte Übersetzungsverhältnisprüfung als Prüfung von einem Spannungswandler als Hochspannungseinrichtung 30 beschrieben. Ein solcher Spannungswandler ist insbesondere eingerichtet, eine primärseitige Hochspannung in eine niedrigere sekundärseitige Spannung zu wandeln und als ein Messsignal bereitzustellen. Eine solche erweiterte Übersetzungsverhältnisprüfung kann insbesondere eine sog. "Power-Quality-Messung" sein, wobei ein lastabhängiges und/oder frequenzabhängiges Übertragungsverhalten des Spannungswandlers bestimmt wird.

Das Prüfsystem ist vorzugsweise in Form einer portablen Prüfvorrichtung ausgestaltet. In einem Ausführungsbeispiel weist das Prüfsystem 10 ein portables Hauptgerät 100 mit einem Gehäuse 140 und ein portables Zusatzgerät mit einem separaten Gehäuse 240 auf. Dabei ist das portable Zusatzgerät als eine Hochspannungsprüfsignalvorrichtung 200 ausgebildet oder weist diese in alternativen Varianten auf. Das Hauptgerät 100 weist eine Messeinrichtung 160, eine Steuerungseinrichtung 180 sowie eine Leistungsverstärkereinrichtung 102 auf, die jeweils innerhalb des Gehäuses 140 angeordnet sind. Weiterhin weist das Hauptgerät 100 eine am Gehäuse angeordnete Anschlussanordnung 120 auf. Das Zusatzgerät 200 bzw. die Hochspannungsprüfsignalvorrichtung 200 weist eine hochspannungsfähige Signalquelle 270, eine Gleichrichtereinrichtung 250, eine Hochspannungssensoreinrichtung 260, eine Stromsensoreinrichtung 292, eine weitere Spannungssensoreinrichtung 296, automatisch durch die Steuerungseinrichtung 180 steuerbare Schaltmittel 280 sowie erste bis vierte Knotenpunkte 271-274 auf, die jeweils innerhalb des Gehäuses 240 angeordnet sind. Weiterhin weist das Zusatzgerät 200 bzw. die Hochspannungsprüfsignalvorrichtung 200 eine Anschlussanordnung 220 sowie einen ersten Hochspannungsanschluss 231 und einen zweiten Hochspannungsanschluss 232 sowie einen ersten Messanschluss 236 und einen zweiten Messanschluss 237 auf, die jeweils am Gehäuse 240 angeordnet sind. Dabei sind das Hauptgerät 100 und das Zusatzgerät 200 über ihre Anschlussanordnungen 120, 220 miteinander mittels eines Kabels 20 oder auf andere Weise verbindbar, wobei das Kabel 20 in einigen Varianten ein Bestandteil des Prüfsystems 10 und in anderen Varianten kein Bestandteil davon ist.

Zudem ist das portable Hauptgerät 100 in einigen Varianten eingerichtet, gesteuert durch die Steuerungseinrichtung 180 ein Steuerungssignal für eine Prüfung der Hochspannungseinrichtung und mittels der Leistungsverstärkereinrichtung 102 ein entsprechendes Leistungssignal zu erzeugen sowie das Steuerungssignal und das Leistungssignal über die Anschlussanordnungen 120, 220 zu übertragen und ein Messsignal, das die erfassten Ströme und Spannungen repräsentiert oder kennzeichnet, darüber von der Hochspannungsprüfsignalvorrichtung 200 zu empfangen.

In weiteren alternativen Varianten weist die Hochspannungsprüfsignalvorrichtung 200 die Messeinrichtung 160, die Steuerungseinrichtung 180 und gegebenenfalls die Leistungsverstärkereinrichtung 102 auf, während die Anschlussanordnung 220 nicht vorhanden ist, sodass die Hochspannungsprüfsignalvorrichtung 200 die multifunktionale Prüfung der Hochspannungseinrichtung eigenständig - also insbesondere ohne dem Hauptgerät 100 - durchführen kann und somit als ein "Stand-alone-Gerät" ausgebildet ist.

Die Leistungsverstärkereinrichtung 102 ist eingerichtet, gesteuert durch die Steuerungseinrichtung 180 Leistungssignale für die Prüfung zu erzeugen, wobei die hochspannungsfähige Signalquelle 270 einen Hochspannungstransformator aufweist und eingerichtet ist, aus diesen Leistungssignalen mittels des Hochspannungstransformators eine Wechselspannung, die einen höheren effektiv Spannungswert als das Leistungssignal aufweisen kann, zu erzeugen. Dabei ist die hochspannungsfähige Signalquelle 270 eingerichtet, die Wechselspannung zwischen dem ersten Knotenpunkt 271 und dem zweiten Knotenpunkt 272 zu erzeugen. In alternativen Varianten ist die hochspannungsfähige Signalquelle 270 eingerichtet, derartige Wechselspannungen transformatorlos oder zumindest ohne den Hochspannungstransformator zu erzeugen, wobei in einigen Varianten davon die Leistungsverstärkereinrichtung 102 entfallen kann.

Die Gleichrichtereinrichtung 250 weist einen ersten Eingangsanschluss 251 und einen zweiten Eingangsanschluss 252 auf. Dabei ist die hochspannungsfähige Signalquelle 270 zudem eingerichtet, eine an die Eingangsanschlüsse 251, 252 angelegte Spannung - insbesondere Wechselspannung - mittels der Gleichrichtereinrichtung 250 gleichzurichten und als eine Gleichspannung zwischen dem dritten Knotenpunkt 273 und dem vierten Knotenpunkt 274 bereitzustellen. In einigen alternativen Varianten ist die hochspannungsfähige Signalquelle 270 auch eingerichtet, die Gleichspannung auf eine andere Weise - etwa mittels einer von der Wechselspannung bzw. dem Hochspannungstransformator unabhängigen hochspannungsfähigen Gleichspannungsquelle - bereitzustellen bzw. zu erzeugen.

Die Hochspannungssensoreinrichtung 260 weist zum Erfassen einer zwischen dem ersten und dem zweiten Hochspannungsanschluss 231, 232 anliegenden Wechselspannung einen Stromsensor 262 und einen in Reihe geschalteten Hochspannungskondensator 264 mit einer bestimmten Kapazität auf. Dabei ist die Messeinrichtung 160 oder die Hochspannungssensoreinrichtung 260 eingerichtet, basierend auf der bestimmten Kapazität und einer bestimmten Frequenz der Wechselspannung oder einem bestimmten Frequenzspektrum bzw. bestimmten Frequenzanteilen der Wechselspannung sowie basierend auf einem mittels des Stromsensors 262 erfassten (Wechsel-)Strom die anliegende Wechselspannung zu bestimmen und zu erfassen. Außerdem weist die Hochspannungssensoreinrichtung 260 zum Erfassen einer zwischen dem dritten und dem vierten Knotenpunkt 273, 274 anliegenden (Gleich-)Spannung einen weiteren Stromsensor 266 und einen in Reihe geschalteten Hochspannungswiderstand 268 mit einem bestimmten Widerstandswert auf. Dabei ist die Messeinrichtung 160 oder die Hochspannungssensoreinrichtung 260 eingerichtet, basierend auf dem bestimmten Widerstandswert und einem mittels des weiteren Stromsensors 266 erfassten (Gleich-)Strom die anliegende (Gleich-)Spannung zu erfassen. Auf diese vorteilhafte Weise lassen sich die zu erfassenden Hochspannungen auf geringere Spannungen und entsprechende Ströme reduzieren, wodurch insbesondere deren Erfassung vereinfacht und/oder sicherer gemacht werden kann. In alternativen Varianten lässt sich auch die anliegende Wechselspannung mittels des weiteren Stromsensors 266 und des Hochspannungswiderstand 268 erfassen. In noch weiteren Varianten ist die Hochspannungssensoreinrichtung 260 eingerichtet, die anliegende Wechselspannung und/oder die anliegende Gleichspannung auf eine andere Weise - etwa mittels eines opto-elektrischen Effekts - zu erfassen. Die Stromsensoreinrichtung 292 ist mit dem zweiten Hochspannungsanschluss 232 elektrisch verbunden und eingerichtet, einen durch diesen fließenden elektrischen Strom zu erfassen. Die weitere Spannungssensoreinrichtung 296 ist mit dem ersten Messanschluss 236 und dem zweiten Messanschluss 237 elektrisch verbunden und eingerichtet, eine dazwischen anliegende Spannung zu erfassen.

Die Hochspannungsprüfsignalvorrichtung 200 ist zumindest in einem Verlustfaktor-Modus für eine Verlustfaktorprüfung der Hochspannungseinrichtung 30, in einem Isolationswiderstand-Modus für eine Isolationswiderstandsprüfung der Hochspannungseinrichtung 30 und in einem erweiterten Übersetzungsverhältnis-Modus für eine erweiterte Übersetzungsverhältnisprüfung der Hochspannungseinrichtung 30 - also insbesondere für eine "Power Quality Messung" - betreibbar, womit diese insbesondere eine multifunktionale Prüfung der Hochspannungseinrichtung ermöglicht. In einigen vorteilhaften Varianten ist die Hochspannungsprüfsignalvorrichtung 200 außerdem in einem Magnetisierungsstrom-Modus betreibbar, um einen Magnetisierungsstrom der Hochspannungseinrichtung zu bestimmen.

Für die erweiterte Übersetzungsverhältnisprüfung ist der erste Primäranschluss 31 an den ersten Hochspannungsanschluss 231 und der zweite Primäranschluss 33 an den zweiten Hochspannungsanschluss 232 sowie der erste Sekundäranschluss 32 an den ersten Messanschluss 236 und der zweite Sekundäranschluss 34 an den zweiten Messanschluss 237 anzuschließen. Die Steuerungseinrichtung 180 ist eingerichtet, für die erweiterte Übersetzungsverhältnisprüfung die Hochspannungsprüfsignalvorrichtung 200 im erweiterten Übersetzungsverhältnis-Modus zu betreiben und mittels der Leistungsverstärkereinrichtung 102 ein derartiges Leistungssignal zu erzeugen, welches die mit dem Leistungssignal gespeiste die hochspannungsfähige Signalquelle 270 veranlasst, mittels des Hochspannungstransformators eine Wechselspannung zu erzeugen, welche wenigstens zwei Frequenzanteile mit unterschiedlichen Effektivwerten aufweist. Dabei kann die Steuerungseinrichtung 180 auch eingerichtet sein, einen sog. "Frequency Sweep", also eine Sequenz von Frequenzen über einen vorgegebenen Frequenzbereich durchzuführen. Im erweiterten Übersetzungsverhältnis-Modus ist die Hochspannungsprüfsignalvorrichtung 200, wie in Fig. 1 dargestellt, eingerichtet, gesteuert durch die Steuerungseinrichtung 180 mittels der Schaltmittel 280 den ersten Knotenpunkt 271 mit dem ersten Hochspannungsanschluss 231 und den zweiten Knotenpunkt 272 mit dem zweiten Hochspannungsanschluss 232 elektrisch lösbar zu verbinden sowie - zumindest in einigen Varianten - den ersten und den zweiten Eingangsanschluss 251, 252 vom ersten und zweiten Knotenpunkt 271, 272 und den dritten und vierten Knotenpunkt 273, 274 vom ersten und zweiten Hochspannungsanschluss 231, 232 elektrisch zu trennen. Weiterhin ist das Hauptgerät 100 und/oder die Steuerungseinrichtung 180 im erweiterten Übersetzungsverhältnis-Modus eingerichtet, ein Messsignal zu empfangen, das die von der Hochspannungssensoreinrichtung 260 erfasste Spannung und die von der weiteren Spannungssensoreinrichtung 296 erfasste Spannung kennzeichnet, und basierend darauf mittels der Messeinrichtung 160 ein Kennfeld von Übersetzungsverhältnissen zwischen der primärseitigen und der sekundärseitigen Spannung in Abhängigkeit von den Frequenzanteilen und deren Effektivwerten zu bestimmen.

Während im erweiterten Übersetzungsverhältnis-Modus insbesondere ein Übertragungsverhalten und damit ein Übersetzungsverhältnis bei gleichzeitiger Last mit verschiedenen Frequenzen und etwaig verschiedenen Amplituden bestimmt wird, ist die Hochspannungsprüfsignalvorrichtung 200 in einigen Varianten auch in einem (einfachen) Übersetzungsverhältnis-Modus betreibbar, wobei für eine (einfache) Übersetzungsverhältnisprüfung das Übertragungsverhalten und damit das Übersetzungsverhältnis jeweils für eine Frequenz - und in einigen Varianten davon zeitlich nacheinander über mehrere Frequenzen, d. h. insbesondere als sog. "Frequency Sweep" - bestimmt wird.

Sowohl für die Verlustfaktorprüfung als auch für die Isolationswiderstandsprüfung sind die Primäranschlüsse 31, 33 an den ersten Hochspannungsanschluss 231 sowie sind die Sekundäranschlüsse 32, 34 an den zweiten Hochspannungsanschluss 232 anzuschließen (der Übersichtlichkeit halber nicht in Fig. 1 dargestellt).

Die Steuerungseinrichtung 180 ist eingerichtet, für die Verlustfaktorprüfung die Hochspannungsprüfsignalvorrichtung 200 im Verlustfaktor-Modus zu betreiben, sodass die mittels der Schaltmittel 280 hergestellten/gelösten elektrischen Verbindungen jenen bezüglich des erweiterten Übersetzungsverhältnis-Modus entsprechen, und mittels der Leistungsverstärkereinrichtung 102 ein derartiges Leistungssignal zu erzeugen, welches die mit diesem Leistungssignal gespeiste hochspannungsfähige Signalquelle 270 veranlasst, mittels des Hochspannungstransformators die gewünschte Wechselspannung zu erzeugen. Weiterhin ist das Hauptgerät 100 und/oder die Steuerungseinrichtung 180 im Verlustfaktor-Modus eingerichtet, ein Messsignal zu empfangen, das den von der Stromsensoreinrichtung 292 erfassten Wechselstrom und etwaig eine von der Hochspannungssensoreinrichtung 260 erfasste Wechselspannung oder eine Phasenlage des erfassten Wechselstroms gegenüber der angelegten oder erfassten Wechselspannung kennzeichnet, und basierend darauf mittels der Messeinrichtung 160 einen Verlustfaktor der Hochspannungseinrichtung 30 zu bestimmen.

Die Steuerungseinrichtung 180 ist eingerichtet, für die Isolationswiderstandsprüfung die Hochspannungsprüfsignalvorrichtung 200 im Isolationswiderstand-Modus zu betreiben, in welchem diese eingerichtet ist, gesteuert durch die Steuerungseinrichtung 180 mittels der Schaltmittel 280 den ersten und den zweiten Knotenpunkt 271, 272 vom ersten bzw. zweiten Hochspannungsanschluss 231, 232 elektrisch zu trennen sowie den ersten Eingangsanschluss 251 mit dem ersten Knotenpunkt 271 und den zweiten Eingangsanschluss 252 mit dem zweiten Knotenpunkt 272 elektrisch lösbar zu verbinden sowie den dritten Knotenpunkt 273 mit dem ersten Hochspannungsanschluss 231 und den vierten Knotenpunkt 274 mit dem zweiten Hochspannungsanschluss 232 elektrisch lösbar zu verbinden. Zudem ist das Hauptgerät 100 und/oder die Steuerungseinrichtung 180 im Isolationswiderstand-Modus eingerichtet, mittels der Leistungsverstärkereinrichtung 102 ein derartiges Leistungssignal zu erzeugen, welches die mit dem Leistungssignal gespeiste hochspannungsfähige Signalquelle 270 veranlasst, mittels des Hochspannungstransformators zunächst eine Wechselspannung zu erzeugen, diese mittels der Gleichrichtereinrichtung 250 gleichzurichten und somit als die Gleichspannung, beispielsweise entsprechend dem Effektivwert der Wechselspannung beim Verlustfaktor-Modus oder beim erweiterten Übertragungsverfahrens-Modus, bereitzustellen. Weiterhin ist das Hauptgerät 100 und/oder die Steuerungseinrichtung 180 im Isolationswiderstand-Modus eingerichtet, ein Messsignal zu empfangen, das den von der Stromsensoreinrichtung 292 erfassten Strom und die von der Hochspannungssensoreinrichtung 260 erfasste Spannung kennzeichnet, und basierend darauf mittels der Messeinrichtung 160 einen Gleichspannungs-Isolationswiderstand der Hochspannungseinrichtung 30 zu bestimmen.

Die Hochspannungsprüfsignalvorrichtung 200 kann weiterhin derart ausgestaltet sein, dass sie in einem Magnetisierungsstrom-Modus für eine Magnetisierungsstromprüfung betreibbar ist, wobei die Hochspannungsprüfsignalvorrichtung in diesem Modus die Wechselspannung an die beiden Hochspannungsanschlüsse 231, 232 und somit an eine Induktivität der Hochspannungseinrichtung 30, welche einen magnetisierbaren Kern aufweist, anlegt. Die Steuerungseinrichtung 180 steuert die Hochspannungsprüfsignalvorrichtung 200, um diese in dem Magnetisierungsstrom-Modus zu betreiben und mittels der Messeinrichtung 160 anhand des von der Stromsensoreinrichtung 292 erfassten Stroms und anhand der von der Hochspannungssensoreinrichtung 260 erfassten Spannung einen Magnetisierungsstrom für die erfasste Spannung zu bestimmen.

In einigen vorteilhaften Varianten für eine mehrphasige Hochspannungseinrichtung weist die Hochspannungsprüfsignalvorrichtung 200 weitere Kanäle mit weiteren Hochspannungsanschlüssen und/oder weiteren Messanschlüssen für die mehreren Phasen der Hochspannungseinrichtung auf, sodass sich eine mehrphasige Prüfung - etwa des Isolationswiderstands und des Verlustfaktors - ohne Änderung der Verkabelung und damit effizienter und/oder sicherer durchführen lässt.

Während Ausführungsbeispiele insbesondere unter Bezugnahme auf die Figur detailliert beschrieben worden sind, sei darauf hingewiesen, dass es sich bei den exemplarischen Ausführungen lediglich um Beispiele handelt, die den Schutzbereich, die Anwendung und den Aufbau in keiner Weise einschränken sollen. Vielmehr wird dem Fachmann durch die vorausgehende Beschreibung ein Leitfaden für die Umsetzung von mindestens einem Ausführungsbeispiel gegeben, wobei diverse Abwandlungen, insbesondere alternative oder zusätzliche Merkmale und/oder Abwandlungen der Funktion und/oder Anordnungen der beschriebenen Bestandteile, nach Wunsch des Fachmanns vorgenommen werden können, ohne dass dabei von dem in den angehängten Ansprüchen jeweils festgelegten Gegenstand sowie seiner rechtlichen Äquivalente abgewichen wird und/oder deren Schutzbereich verlassen wird.

## Patentansprüche

1. Prüfsystem (10) für eine multifunktionale Prüfung einer Hochspannungseinrichtung (30), welche eine Primärseite und eine davon elektrisch isolierte Sekundärseite aufweist,
wobei das Prüfsystem (10) eine Hochspannungsprüfsignalvorrichtung (200), eine Messeinrichtung (160) und eine Steuerungseinrichtung (180) aufweist,
wobei die Hochspannungsprüfsignalvorrichtung (200) aufweist:
eine hochspannungsfähige Signalquelle (270), die eingerichtet ist, eine Wechselspannung sowie eine Gleichspannung zu erzeugen,
einen Hochspannungsanschluss (231; 232) zum Anschließen der Hochspannungseinrichtung (30),
eine Stromsensoreinrichtung (292), die eingerichtet ist, einen über den Hochspannungsanschluss (231; 232) fließenden elektrischen Strom zu erfassen, und
eine Hochspannungssensoreinrichtung (260), die eingerichtet ist, eine an dem Hochspannungsanschluss (231; 232) anliegende elektrische Spannung zu erfassen,
wobei die Hochspannungsprüfsignalvorrichtung (200) in einem Verlustfaktor-Modus für eine Verlustfaktorprüfung der Hochspannungseinrichtung und in einem Isolationswiderstand-Modus für eine Isolationswiderstandsprüfung der Hochspannungseinrichtung betreibbar ist, wobei die Hochspannungsprüfsignalvorrichtung (200) eingerichtet ist, in dem Verlustfaktor-Modus die Wechselspannung und in dem Isolationswiderstand-Modus die Gleichspannung an den Hochspannungsanschluss anzulegen, und
wobei die Steuerungseinrichtung (180) eingerichtet ist:
- für die Verlustfaktorprüfung die Hochspannungsprüfsignalvorrichtung im Verlustfaktor-Modus zu betreiben und mittels der Messeinrichtung (160) anhand des von der Stromsensoreinrichtung (292) erfassten Stroms einen Verlustfaktor der Hochspannungseinrichtung (30) zu bestimmen, und
- für die Isolationswiderstandsprüfung die Hochspannungsprüfsignalvorrichtung im Isolationswiderstand-Modus zu betreiben und mittels der Messeinrichtung (160) anhand des von der Stromsensoreinrichtung erfassten Stroms und anhand der von der Hochspannungssensoreinrichtung (260) erfassten Spannung einen Gleichspannungs-Isolationswiderstand der Hochspannungseinrichtung (30) zu bestimmen,
wobei die Hochspannungsprüfsignalvorrichtung (200) einen Messanschluss (236, 237) und eine weitere Spannungssensoreinrichtung (296), die eingerichtet ist, eine an dem Messanschluss (236, 237) anliegende elektrische Spannung zu erfassen, aufweist,
wobei die Hochspannungsprüfsignalvorrichtung (200) in einem Übersetzungsverhältnis-Modus für eine Übersetzungsverhältnisprüfung der Hochspannungseinrichtung (30) betreibbar ist, für welche die Primärseite der Hochspannungseinrichtung (30) an den Hochspannungsanschluss (231, 232) und die Sekundärseite der Hochspannungseinrichtung (30) an den Messanschluss (236, 237) anzuschließen ist,
wobei die Hochspannungsprüfsignalvorrichtung (200) eingerichtet ist, in dem Übersetzungsverhältnis-Modus die Wechselspannung mittels der hochspannungsfähigen Signalquelle (270) zu erzeugen und an den Hochspannungsanschluss (231, 232) anzulegen, und
wobei die Steuerungseinrichtung (180) eingerichtet ist, für die Übersetzungsverhältnisprüfung die Hochspannungsprüfsignalvorrichtung (200) in dem Übersetzungsverhältnis-Modus zu betreiben und mittels der Messeinrichtung (160) anhand der von der Hochspannungssensoreinrichtung (260) erfassten Spannung und anhand der von der weiteren Spannungssensoreinrichtung (296) erfassten Spannung, welche infolge der an die Primärseite der Hochspannungseinrichtung (30) anliegenden Wechselspannung an der Sekundärseite der Hochspannungseinrichtung (30) und damit an dem Messanschluss anliegt, ein Übersetzungsverhältnis der Hochspannungseinrichtung (30) zu bestimmen,
**dadurch gekennzeichnet, dass** die Hochspannungseinrichtung (30) ein Spannungswandler ist,
wobei die Hochspannungsprüfsignalvorrichtung (200) weiterhin in einem erweiterten Übersetzungsverhältnis-Modus betreibbar ist, und
wobei die Steuerungseinrichtung (180) eingerichtet ist, für eine erweiterte Übersetzungsverhältnisprüfung die Hochspannungsprüfsignalvorrichtung (200) in dem erweiterten Übersetzungsverhältnis-Modus zu betreiben, um die Hochspannungsprüfsignalvorrichtung (200) zu veranlassen, eine Wechselspannung mittels der hochspannungsfähigen Signalquelle (270) zu erzeugen, welche wenigstens zwei Frequenzanteile mit unterschiedlichen Effektivwerten aufweist, und mittels der Messeinrichtung (160) anhand der von der Hochspannungssensoreinrichtung (260) erfassten Spannung und anhand der von der weiteren Spannungssensoreinrichtung (296) erfassten Spannung ein Kennfeld von Übersetzungsverhältnissen der Hochspannungseinrichtung (30) in Abhängigkeit von den Frequenzanteilen und deren Effektivwerten zu bestimmen.

2. Prüfsystem (10) gemäß Anspruch 1, wobei die hochspannungsfähige Signalquelle (270) einen Hochspannungstransformator zur Erzeugung der Wechselspannung umfasst.

3. Prüfsystem (10) gemäß Anspruch 2,
wobei die Hochspannungsprüfsignalvorrichtung (200) automatisch durch die Steuerungseinrichtung steuerbare Schaltmittel (280) sowie eine Gleichrichtereinrichtung (250) mit einem ersten (251) und einem zweiten (252) Eingangsanschluss aufweist,
wobei die hochspannungsfähige Signalquelle (270) eingerichtet ist, die Wechselspannung zwischen einem ersten und einem zweiten Knotenpunkt (271, 272) zu erzeugen und/oder die Wechselspannung mittels der Gleichrichtereinrichtung (250) gleichzurichten und als die Gleichspannung zwischen einem dritten (273) und einem vierten Knotenpunkt (274) bereitzustellen, und
wobei die Steuerungseinrichtung (180) eingerichtet ist:
- für die Verlustfaktorprüfung mittels der steuerbaren Schaltmittel (280) den ersten Knotenpunkt (271) mit einem ersten Hochspannungsanschluss (231) des Prüfsystems und den zweiten Knotenpunkt (272) mit einem zweiten Hochspannungsanschluss (232) des Prüfsystems (10) elektrisch lösbar zu verbinden sowie den ersten und zweiten Eingangsanschluss der Gleichrichtereinrichtung (250) vom ersten und zweiten Knotenpunkt (271, 272) elektrisch zu trennen und den dritten und vierten Knotenpunkt (273, 274) vom ersten und zweiten Hochspannungsanschluss (231, 232) elektrisch zu trennen, und
- für die Isolationswiderstandsprüfung mittels der steuerbaren Schaltmittel (280) den ersten und zweiten Knotenpunkt (271, 272) vom ersten bzw. zweiten Hochspannungsanschluss (231, 232) elektrisch zu trennen sowie den ersten Eingangsanschluss der Gleichrichtereinrichtung (250) mit dem ersten Knotenpunkt (271) und den zweiten Eingangsanschluss der Gleichrichtereinrichtung (250) mit dem zweiten Knotenpunkt (272) elektrisch lösbar zu verbinden und den dritten Knotenpunkt (273) mit dem ersten Hochspannungsanschluss (231) und den vierten Knotenpunkt (274) mit dem zweiten Hochspannungsanschluss (232) elektrisch lösbar zu verbinden.

4. Prüfsystem (10) gemäß einem der vorhergehenden Ansprüche, wobei die Hochspannungssensoreinrichtung (260) zum Erfassen einer an dem Hochspannungsanschluss (231, 232) anliegenden Wechselspannung einen Stromsensor (262) und einen in Reihe geschalteten Hochspannungskondensator (264) mit einer bestimmten Kapazität aufweist.

5. Prüfsystem (10) gemäß einem der vorhergehenden Ansprüche,
wobei Hochspannungseinrichtung (30) eine Induktivität mit einem magnetisierbaren Kern aufweist,
wobei die Hochspannungsprüfsignalvorrichtung (200) weiterhin in einem Magnetisierungsstrom-Modus für eine Magnetisierungsstromprüfung betreibbar ist, wobei die Hochspannungsprüfsignalvorrichtung (200) eingerichtet ist, um in dem Magnetisierungsstrom-Modus die Wechselspannung an den Hochspannungsanschluss (231, 232) und somit an die Induktivität der Hochspannungseinrichtung (30) anzulegen, und
wobei die Steuerungseinrichtung (180) eingerichtet ist, für die Magnetisierungsstromprüfung die Hochspannungsprüfsignalvorrichtung (200) in dem Magnetisierungsstrom-Modus zu betreiben und mittels der Messeinrichtung (160) anhand des von der Stromsensoreinrichtung (292) erfassten Stroms und anhand der von der Hochspannungssensoreinrichtung (260) erfassten Spannung einen Magnetisierungsstrom für die erfasste Spannung zu bestimmen.

6. Prüfsystem (10) nach einem der vorhergehenden Ansprüche, wobei das Prüfsystem (10) mit der Hochspannungsprüfsignalvorrichtung (200), der Messeinrichtung (160) und der Steuerungseinrichtung (180) in Form einer portablen Prüfvorrichtung ausgestaltet ist.

7. Prüfsystem (10) gemäß einem der vorhergehenden Ansprüche, aufweisend:
ein portables Hauptgerät (100) mit einem Gehäuse (140) und einer daran angeordneten Anschlussanordnung (120), und
ein portables Zusatzgerät mit einem separaten Gehäuse (240) und einer daran angeordneten Anschlussanordnung (220),
wobei das portable Hauptgerät (100) die Messeinrichtung (160), die Steuerungseinrichtung (180) und eine Leistungsverstärkereinrichtung (102) zum Erzeugen eines Leistungssignals aufweist,
wobei das portable Zusatzgerät die Hochspannungsprüfsignalvorrichtung (200) aufweist und das portable Hauptgerät (100) und das portable Zusatzgerät über ihre Anschlussanordnungen (120, 220) miteinander verbindbar sind, und
wobei das portable Hauptgerät (100) eingerichtet ist, um gesteuert durch die Steuerungseinrichtung (180) ein Steuerungssignal für eine Prüfung der Hochspannungseinrichtung (30) und mittels der Leistungsverstärkereinrichtung ein entsprechendes Leistungssignal zu erzeugen und über die Anschlussanordnungen (120, 220) zu übertragen sowie ein Messsignal, das die erfassten Ströme und Spannungen bezeichnet, über die Anschlussanordnungen (120. 220) von der Hochspannungsprüfsignalvorrichtung (200) zu empfangen.

8. Verfahren für eine multifunktionale Prüfung einer Hochspannungseinrichtung (30) mit Hilfe eines Prüfsystems (10),
wobei die Hochspannungseinrichtung (30) eine Primärseite und eine davon elektrisch isolierte Sekundärseite aufweist und die Hochspannungseinrichtung (30) zur Durchführung der Prüfung mit dem Prüfsystem (10) verbunden wird, und wobei das Verfahren die folgenden von dem Prüfsystem (10) automatisch durchgeführten Schritte umfasst:
- Erzeugen einer Wechselspannung durch das Prüfsystem (10) und Anlegen der Wechselspannung an die Hochspannungseinrichtung (30),
- Erfassen eines elektrischen Wechselstroms, der in Folge der Wechselspannung über die Hochspannungseinrichtung (30) fließt,
- Bestimmen eines Verlustfaktors anhand des erfassten Wechselstroms,
- Erzeugen einer Gleichspannung durch das Prüfsystem (10) und Anlegen der Gleichspannung an die Hochspannungseinrichtung (30),
- Erfassen eines elektrischen Gleichstroms, der in Folge der Gleichspannung über die Hochspannungseinrichtung (30) fließt, und
- Bestimmen eines Gleichspannungs-Isolationswiderstands der Hochspannungseinrichtung (30) anhand des erfassten Gleichstroms und anhand der Gleichspannung,
wobei das Verfahren mit dem Prüfsystem (10) nach einem der Ansprüche 1-7 durchgeführt wird.
